# EUROPÄISCHE PATENTSCHRIFT

(11) **EP 4 102 211 B1**
(45) Veröffentlichungstag und Bekanntmachung des Hinweises auf die Patenterteilung: **03.12.2025**
(21) Anmeldenummer: 22020252.7
(22) Anmeldetag: 31.05.2022
(51) Int. Cl.: G01N 21/91, G01N 21/95, G01R 31/70, G01R 31/67, H04B 17/12

(54) **VERFAHREN ZUM BESTIMMEN DER QUALITÄT EINER ELEKTRISCHEN VERBINDUNG**
METHOD FOR DETERMINING THE QUALITY OF AN ELECTRICAL CONNECTION
PROCÉDÉ DE DÉTERMINATION DE LA QUALITÉ D'UNE CONNEXION ÉLECTRIQUE

(30) Priorität: 11.06.2021 DE 102021003014
(43) Veröffentlichungstag der Anmeldung: 14.12.2022
(73) Patentinhaber: Giesecke+Devrient ePayments GmbH, 81677 München (DE)
(72) Erfinder: Baldischweiler, Michael, 81825 München (DE); Stolper, Philipp, 85567 Grafing (DE)
(74) Vertreter: Giesecke+Devrient IP

(56) Entgegenhaltungen:
- CN-A- 112 748 062
- US-A- 5 651 493
- US-A1- 2005 018 898
- US-B1- 6 236 220
- US-B1- 8 063 656
- VOGEL GERT: "Schadgas-Tests an elektronischen Komponenten und Baugruppen", SIEMENS, 1 January 2017 (2017-01-01), pages 1 - 41, XP093067886
- "DIN V 40046-36/37: 2006: Umgebungseinfluesse - Teil 36: Pruefverfahren - Pruefung Kx/Ky: Schwefeldioxid/Schwefelwasserstoff, niedrige Konzentration fuer Kontakte und Verbindungen ED - Beuth Verlag", 1 August 2008 (2008-08-01), XP009549122, Retrieved from the Internet <URL:https://www.beuth.de/de/vornorm/din-v-40046-36/91396325> [retrieved on 20231030]

## Beschreibung

Die Erfindung betrifft ein Verfahren zum Bestimmen der Qualität einer elektrischen Verbindung zwischen einem Chip und einer Antenne einer kontaktlos arbeitenden Chipkarte.

In einer kontaktlos arbeitenden Chipkarte sind der in der Regel als Chipmodul vorliegende Chip und die als (Antennen-)Spule vorliegende Antenne in einen meist aus Kunststoff bestehenden Kartenkörper eingebettet. Die Herstellung der elektrischen Verbindung zwischen dem Chip und der Antenne erfolgt z.B. mittels sog. Flexbumps, T-Connects, ACF-Klebesystemen oder leitenden Materialien. Bei all diesen grundsätzlich bekannten Anschlusstechniken besteht das Problem, dass sich die Verbindung zwischen dem Chip und der Antenne lösen kann. "Lösen" der Chip-Antenne-Verbindung bedeutet dabei, dass eine komplette Ablösung der Verbindung vorliegen kann. In diesem Fall besteht kein Kontakt mehr zwischen dem Chip und der verwendeten Verbindungstechnik und der Antenne. Unter einem "Lösen" ist aber auch der Fall zu verstehen, in dem der Kontakt nur noch eingeschränkt vorhanden ist.

Schon minimale Ablösungen im Mikrometerbereich führen bei Chip-Antenne-Verbindungen zum vollständigen Funktionsverlust. Es ist daher erforderlich solche Ablösungen zu erkennen und nachweisen zu können. Hierzu wurde eine Reihe von Testverfahren, wie z.B. Röntgenverfahren, Microtomschnitt oder elektrische Verfahren entwickelt.

Wenn sich die Kontaktflächen nur wenige Mikrometer voneinander entfernen ist ein Nachweis der Ablösung mittels Röntgenverfahren oder Microtomschnitt nicht bzw. nur schwierig möglich. Zudem ist zur Durchführung dieser Verfahren teure Analysetechnik erforderlich. Beim Microtomschnitt besteht zusätzlich das Problem, dass sich der gesamte Kartenaufbau mechanisch durch den Schnitt verändert. Durch diese Vorgehensweise kann daher nicht nachgewiesen werden, ob es sich um eine komplette Ablösung oder nur um eine Teilablösung der Verbindung handelt.

Das elektrische Testen von Chip-Antenne-Verbindungen ist z.B. in der US 6 236 220 B1 beschrieben. Die hier beschriebene Lösung beruht auf einer abrupt unterbrochenen Anregung der Antenne als Teil eines Schwingkreises. Auch bei diesem Verfahren ist aufwendige Analysetechnik erforderlich.

Aus der Veröffentlichung "Schadgas-Tests an elektronischen Komponenten und Baugruppen", G.Vogel, Konferenz: Ausfallursachen und Schadenanalytik in elektronische Baugruppen, Siemens, 1. Januar 2017, ist ein Schnelltest bekannt, nach dem ein zu untersuchendes Bauteil in einer Prüfkammer unter bestimmten Bedingungen einer Atmosphäre mit einem hohem Gehalt von Schwefelwasserstoff ausgesetzt wird. Die anschließende Beurteilung der getesteten Bauteile kann mittels optischer Mikroskopie, mittels Röntgenbildern oder mittels Röntgenfluoreszenzanalyse erfolgen.

Aus der DIN-Vornorm V 40046-36/37, August 2006: Umgebungseinflüsse - Teil 36: Prüfverfahren - Prüfung Kx: Schwefeldioxid, niedrige Konzentration für Kontakte und Verbindungen, Beuth Verlag, verfügbar im Internet unter: https://www.beuth.de/de/vornorm/dinv-40046-36/91396325, ist für die Durchführung einer zeitraffenden Prüfung der korrosiven Wirkung von mit Schwefeldioxid versetzter Luft auf elektrische Verbindungen eine aus einem Klimasystem, einer Prüfkammer, einem Gasversorgungssystem und einer Messeinrichtung für die Gaskonzentration bestehende Prüfeinrichtung bekannt, die geeignet ist, eine Prüfatmosphäre durch unmittelbares Mischen der erforderlichen Bestandteile herzustellen. In die Prüfkammer wird ein Prüfling eingebracht.

Es ist Aufgabe der Erfindung, die Qualität der Verbindungen zwischen einem Chip und einer Antenne einer Chipkarte zuverlässig bestimmen zu können. Im Fall von festgestellten Fehlern besteht das Ziel, die Ursache ausfindig machen zu können, um insbesondere Schwächen in einem Herstellungsprozess ausfindig machen zu können.

Es wird, wie in Anspruch 1 definiert, ein Verfahren zum Bestimmen der Qualität einer elektrischen Verbindung zwischen einem Chip und der Antenne einer kontaktlos arbeitenden Chipkarte vorgeschlagen. Als Chipkarte sind insbesondere tragbare Datenträger mit RFID-Funktionalität in Kartenform zu verstehen, wie sie beispielsweise als Geldkarten, Kreditkarten und dergleichen bekannt sind. Grundsätzlich kann als Chipkarte jeder andere Gegenstand mit einem, einen Chip aufweisenden Chipmodul und einer Antenne(spule) verstanden werden, der eine RFID-Funktionalität aufweist, wie z.B. Etiketten und dergleichen. Die zwischen dem Chip und der Antenne hergestellte Verbindung kann beispielsweise mittels Flexbump, T-Connect, ACF-Klebesystemen oder anderen leitenden Materialien hergestellt sein.

Das Verfahren umfasst die folgenden Schritte:
In einem Schritt a) wird eine zu untersuchende Chipkarte in eine Schwefelwasserstoff-Umgebung eingebracht, wobei der Schwefelwasserstoff an Oberflächen aus leitfähigem Material eine chemische Reaktion hervorruft, aus der eine Einfärbung resultiert. Der Schwefelwasserstoff dringt, solange die zu untersuchende Chipkarte der Schwefelwasserstoff-Umgebung ausgesetzt ist, in feinste Räume der Chip-Antenne-Verbindung ein und verfärbt bei Kontakt die sie berührten Oberflächen aus dem Leitmaterial. Demgegenüber werden gute, nicht abgelöste Verbindungen nicht verfärbt, da sie keinen Kontakt mit dem Schwefelwasserstoff haben.

Die Lagerung der Chipkarte erfolgt bei der Durchführung des Schrittes a) in einem ersten Raum eines zwei Räume aufweisenden Behandlungsgerätes, wobei der erste Raum von einem zweiten Raum, in dem Natriumsulfid angeordnet ist, durch eine Öffnungen aufweisende Trennplatte getrennt ist.

Als Behandlungsgerät kann beispielsweise ein Exsikkator, wie dieser als chemisches Laborgerät zur Trocknung fester chemischer Stoffe bekannt ist, verwendet werden. Bei einem Exsikkator handelt es sich bekanntermaßen um ein meist aus dickwandigem Glas oder Kunststoff gefertigtes Gefäß, welches durch einen mit Planschliff versehenen Deckel luftdicht verschlossen wird oder werden kann. Ein unterer Teil des Exsikkators wird durch eine Siebplatte aus Keramik oder Kunststoff abgetrennt und typischerweise mit einem Trocknungsmittel befüllt. Auf der Siebplatte steht ein offenes Gefäß, mit dem ein zu trocknendes Gut zu trocknen ist.

In einem Schritt b) wird die elektrische Verbindung zwischen dem Chip und der Antenne der zu untersuchenden Chipkarte aufgetrennt. Das Auftrennen der elektrischen Verbindung kann mechanisch, beispielsweise durch Sägen, Schneiden oder eine andere Trennmethode, erfolgen.

In Schritt c) erfolgt das Durchführen einer optischen Analyse der aufgetrennten Bereiche, bei der eine Auswertung der eine Einfärbung aufweisenden Flächenbereiche mit den keine Einfärbung aufweisenden Flächenbereichen jeweiliger aufgetrennter Bereiche durchgeführt wird. Die Auswertung kann qualitativer und/oder quantitativer Art erfolgen. Beispielsweise kann lediglich festgestellt werden, ob die aufgetrennte elektrische Verbindung eine Einfärbung aufweist oder nicht. Weist die Chip-Antenne-Verbindung keine Einfärbung auf, so war, wie oben beschrieben, die elektrische Verbindung gut, d.h. nicht abgelöst. Ist demgegenüber eine Einfärbung zu erkennen, so ist die elektrische aufgetrennte Verbindung fehlerbehaftet. Die Auswertung kann alternativ oder zusätzlich die Bestimmung umfassen, wie groß der prozentuale Anteil eingefärbter Flächenbereiche zur Gesamtfläche des oder der aufgetrennten Chip-Antenne-Verbindung ist. Die Auswertung kann alternativ oder zusätzlich umfassen, wie das Flächenverhältnis von eingefärbten Bereichen zu nicht eingefärbten Bereichen der aufgetrennten Chip-Antenne-Verbindung ist.

Auf diese Weise ist zuverlässig und einfach eine optische Beurteilung der Verbindung möglich. Diese kann sehr kostengünstig realisiert werden. Sie kommt insbesondere ohne spezielle Messtechnik aus. Das Verfahren ermöglicht den einfachen Nachweis, ob und wo die Verbindung zwischen dem Chip und der Antenne fehlerhaft ist.

Gemäß einer zweckmäßigen Ausgestaltung ist in dem zweiten Raum des Behandlungsgerätes gereinigtes (insbesondere destilliertes) Wasser in einem von dem Natriumsulfid getrennten offenen Behälter angeordnet. Bevor das Behandlungsgerät luftdicht verschlossen wird, wird für eine vorgegebene Zeit gasförmiges Kohlendioxid in dieses eingeleitet, so dass aus den im Inneren des Behandlungsgeräts befindlichen Substanzen Natriumsulfid, Wasser und Kohlendioxid Schwefelwasserstoff entstehen kann.

Zweckmäßig ist die Chipkarte in dem Behandlungsgerät in einem Halterahmen so gehalten, dass sich eine Ebene, in der ihre Hauptfläche liegt, in Schwerkraftrichtung erstreckt. Dies hat den Vorteil, dass zum einen die Hauptflächen der Chipkarte gleichmäßig mit Schwefelwasserstoff umströmt werden können. Zum anderen ist eine raumsparende Anordnung möglich, welche insbesondere das gleichzeitige Einbringen einer Mehrzahl an zu untersuchenden Chipkarten in die Schwefelwasserstoff-Umgebung ermöglicht.

Zweckmäßigerweise weist die zu untersuchende Chipkarte einen Kartenkörper auf, in den der Chip und die Antenne eingebettet sind. Der Kartenkörper besteht zweckmäßigerweise aus Kunststoff, wobei auch andere Materialien denkbar sind. Vor Schritt a) wird in den Kartenkörper von der Rückseite her im Bereich des Chips eine Öffnung eingebracht. Vorzugsweise erfolgt dies im Bereich der Mitte eines den Chip umfassenden Chipmoduls. Die Öffnung weist vorzugseiweise einen Durchmesser von mindestens 1 mm auf. Hierdurch wird die zwischen dem Chip und der Antenne gebildete elektrische Verbindung von außerhalb zugänglich, so dass im Falle einer fehlerhaften Verbindung der Schwefelwasserstoff an dem Leitmaterial eine chemische Reaktion hervorrufen kann, aus der die optisch auswertbare Einfärbung resultiert.

Eine weitere zweckmäßige Ausgestaltung sieht vor, dass in Schritt a) gleichzeitig eine Mehrzahl an zu untersuchenden Chipkarten in die Schwefelwasserstoff-Umgebung eingebracht wird, wie dies weiter oben bereits beschrieben wurde. Bei einer Mehrzahl an zu untersuchenden Chipkarten ist es zweckmäßig, wenn diese - parallel zueinander ausgerichtet - in dem Halterahmen gehalten sind, wobei jeweils zwei Chipkarten mit ihren Rückseiten in unmittelbar benachbarten Steckplätzen des Halterahmens angeordnet sind. In den Steckplätzen benachbart zu diesem Paar an Chipkarten bleibt bevorzugt ein Steckplatz leer. Es ist zudem zweckmäßig, wenn die Reihenfolge der in den Halterahmen eingesteckten Karten dokumentiert wird. Hierzu kann es zweckmäßig sein, an der Seite des Halterahmens eine eindeutige Markierung anzubringen, um später eine Zuordnung zu den in dem Halterahmen eingesteckten Chipkarten zu ermöglichen.

Eine weitere zweckmäßige Ausgestaltung sieht vor, dass die Lagerung der zu untersuchenden Chipkarte in dem verschlossenen Behandlungsgerät für eine vorbestimmte Zeitdauer erfolgt. Es ist zweckmäßig, wenn die vorbestimmte Zeitdauer maximal mehrere Stunden, insbesondere höchstens sechs Stunden, zwölf Stunden, 24 Stunden, 48 Stunden oder 72 Stunden beträgt. Bei Versuchen hat sich herausgestellt, dass bei einer zu langen Einwirkung des Schwefelwasserstoffs auf die Leitflächen der Chipkarte sich der Schwefelwasserstoff in die elektrische Verbindung hineinarbeitet, wobei die Reaktion so stark ist, dass nicht mehr unterschieden werden kann, ob ein Kontakt zwischen Chip und Antenne vorhanden war oder nicht. Eine ausreichend lange Einwirkung des Schwefelwasserstoffs auf die elektrische Verbindung ist jedoch andererseits in der Lage, kalte Lötstellen bei Lötverfahren nachzuweisen, da sich der Schwefelwasserstoff in die Lötverbindung hineinarbeitet und damit auch schlechte elektrische Verbindungen angezeigt werden.

Die optische Analyse in Schritt c) kann zum einen durch einen Menschen, z.B. einen Qualitätsingenieur, erfolgen. Zum anderen kann die optische Analyse aber auch auf Basis eines durch Bilderkennung analysierten Fotos erfolgen. Hierdurch können in kurzer Zeit große Mengen an durch das oben beschriebene Verfahren behandelten Chipkarten auf das Vorliegen von Fehlern in der Chip-Antenne-Verbindung untersucht werden.

Die Erfindung wird nachfolgend näher anhand eines Ausführungsbeispiels in der Zeichnung beschrieben. Es zeigen:
- Fig. 1: eine schematische Darstellung des Ablaufs des erfindungsgemäßen Verfahrens; und
- Fig. 2: eine schematische Querschnittsdarstellung eines Behandlungsgeräts zur Durchführung des erfindungsgemäßen Verfahrens.

Das nachfolgend beschriebene Verfahren dient der Bestimmung der Qualität einer als Chip-Antenne-Verbindung bezeichneten elektrischen Verbindung zwischen einem Chip und einer Antenne einer kontaktlos arbeitenden Chipkarte.

Als Chipkarte sind grundsätzlich tragbare Datenträger mit RFID (Radio Frequency Identification)-Funktionalität zu verstehen, die eine kontaktlose Kommunikation mit einem Lesegerät erlauben. Typischerweise basieren solche tragbaren Datenträger auf einer Kunststoffkarte im Kreditkartenformat. Der Begriff Chipkarte soll jedoch nicht auf solche bekannten Bauformen beschränkt sein sondern auch andere Ausführungen von tragbaren Datenträgern umfassen, die auf einem Grundkörper beruhen, in dem ein Chip und eine Antenne zur Realisierung einer RFID-Funktionalität angeordnet sind. Für die nachfolgende Beschreibung wird ein Datenträger in Form einer kontaktlos arbeitenden Chipkarte zugrunde gelegt.

Eine solche kontaktlos arbeitende Chipkarte 1 umfasst einen, in der Regel aus Kunststoff bestehenden, Kartenkörper, in den - von außen nicht sichtbar - eine Antenne und ein Chip 5 integriert sind. Der Chip 5 beinhaltet einen integrierten Schaltkreis (IC) und liegt typischerweise in Form eines sog. Chipmoduls vor. Besitzt eine Chipkarte 1 ausschließlich kontaktlose Funktionalität sind Antenne und Chip bzw. Chipmodul 5 von außerhalb des Kartenkörpers nicht erkennbar. Bei einer hybriden Chipkarte, welche sowohl über eine Kontaktlosfunktion als auch über Kontakte verfügt, sind auf einer Oberseite des Kartenkörpers Kontaktflächen des Chipmoduls 5 erkennbar. Da dem Fachmann der Aufbau solcher Chipkarten bekannt ist, wird an dieser Stelle auf eine eingehende Beschreibung ihres mechanischen Aufbaus verzichtet.

Die zwischen dem Chip 5und der Antenne gebildete elektrische Verbindung ist beispielswiese mittels Flexbump, T-Connect oder einem ACF-Klebesystem hergestellt. Die elektrische Verbindung kann Fehler in Form von Ablösungen aufweisen. Solche Fehler können insbesondere aus dem Produktionsprozess resultieren. Schon minimale Ablösungen im Mikrometerbereich der elektrischen Verbindung führen häufig zum vollständigen Funktionsverlust der Chipkarte und sind deshalb unbedingt zu vermeiden. Die Vermessung der Qualität der Verbindung zwischen dem Chip und der Antenne im Fall von festgestellten Fehlern wird durch das nachfolgend beschriebene Verfahren ermöglicht. Insbesondere ermöglicht das Verfahren, eine Ursache für fehlerhafte Chip-Antenne-Verbindungen im Herstellungsprozess zu finden, um diese für die Zukunft eliminieren zu können.

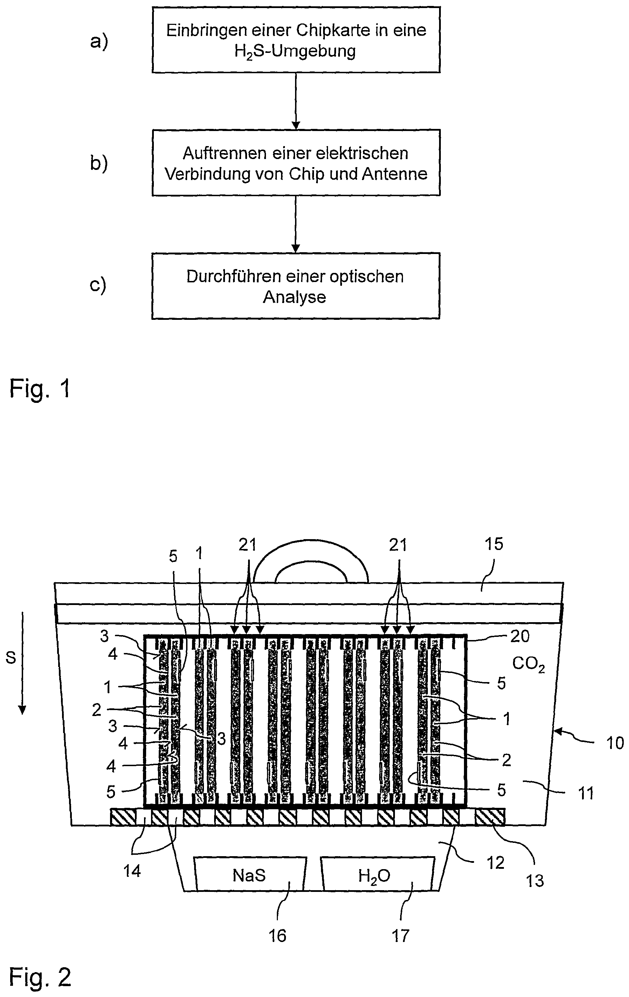

Das Verfahren basiert auf einer eine chemische Reaktion nutzenden Untersuchungsmethode. Hierzu wird die zu untersuchende Chip-Antenne-Verbindung der kontaktlos arbeitenden Chipkarte in eine Schwefelwasserstoff-Umgebung (H₂S-Umgebung) gebracht (Schritt a) von Fig. 1). Der Schwefelwasserstoff dringt, während die Chipkarte in der Schwefelwasserstoff-Umgebung ist, in feinste Räume der Chip-Antenne-Verbindung ein und verfärbt die berührten Oberflächen aus Leitmaterial schwarz. Da gute, nicht abgelöste Verbindungen keinen Kontakt mit dem Schwefelwasserstoff erhalten, werden diese nicht verfärbt. Diese Eigenschaft wird ausgenutzt, indem in Schritt b) ein Auftrennen der elektrischen Verbindung von Chip und Antenne erfolgt. Die in Schritt c) sich anschließende optische Analyse ermöglicht eine Auswertung der eine Einfärbung aufweisenden Flächenbereiche sowie der keine Einfärbung aufweisenden Flächenbereiche jeweils aufgetrennter Bereiche. Die Auswertung gibt Aufschluss über die Qualität der untersuchten elektrischen Verbindung.

Fig. 2 zeigt eine schematische Darstellung einer Vorrichtung zur Durchführung des Schritts a), mit dem eine oder mehrere zu untersuchende Chipkarten in eine Schwefelwasserstoff-Umgebung eingebracht werden, so dass der Schwefelwasserstoff an Oberflächen aus leitfähigem Material eine chemische Reaktion hervorruft, aus der eine auswertbare Einfärbung resultiert.

Als Behandlungsgerät 10 wird vorzugsweise ein Exsikkator verwendet, wie er als chemisches Laborgerät bekannt ist. Das Behandlungsgerät 10 besteht beispielsweise aus transparentem Glas oder Kunststoff. Es umfasst einen ersten Raum 11 und einen in der Regel kleineren zweiten Raum 12, der in Schwerkraftrichtung S unterhalb des ersten Raums 11 angeordnet ist. Der erste Raum 11 und der zweite Raum 12 können über eine als Siebplatte ausgebildete Trennplatte 13, z.B. aus Keramik, voneinander getrennt werden. Der zweite Raum 12 ist zur Aufnahme eines ersten offenen Behälters 16, zweckmäßig in Form einer Schale und eines zweiten offenen Behälters 17, gleichfalls zweckmäßig in Form einer Schale vorgesehen. Als erste und zweite Schale 16, 17 werden beispielsweise Petrischalen verwendet. In die erste Schale 16 werden Natriumsulfid-Flocken gelegt. In die zweite Schale 17 wird destilliertes Wasser gegeben. Es hat sich als zweckmäßig herausgestellt, etwa 2 g Natriumsulfid und 2 ml destilliertes Wasser zu verwenden.

Auf die mit Öffnungen 14 versehende Trennplatte 13 ist ein Halterahmen 20 gestellt. Der Halterahmen 20 umfasst eine Anzahl von Steckplätzen 21. In die Steckplätze 21 sind Chipkarten 1 derart eingebracht, dass zwei Chipkarten 1 paarweise mit ihren Rückseiten 4 einander zugewandt sind. Benachbarte Chipkarten 1, deren Vorderseiten 3 einander zugewandt sind, sind über einen freien Steckplatz 21 zueinander angeordnet.

In dem in Fig. 2 dargestellten Ausführungsbeispiel sind beispielhaft 16 Chipkarten 1 angeordnet. Durch die beschriebene Anordnung kommen die Chips 5 bzw. Chipmodule mit den Chips 5 einander diagonal gegenüber zum Liegen. Es ist zweckmäßig, die Reihenfolge der in den Halterahmen 20 gesteckten Chipkarten 1 zu dokumentieren. Die Anordnung der Chipkarten 1 in dem Halterahmen 20 ist derart, dass sich eine Ebene, in der eine jeweilige Hauptfläche der Chipkarten 1 liegt, in der Schwerkraftrichtung S erstreckt. Die Schwerkraftrichtung entspricht der Richtung des Pfeils S, d.h. in der Blattebene einer Richtung von oben nach unten.

Damit die Schwefelwasserstoff-Umgebung an die elektrischen Verbindungen zwischen Chip und Antenne gelangen kann, muss in den jeweiligen Kartenkörper 2 von der Rückseite 4 der Chipkarte 1 her eine Öffnung (nicht dargestellt) eingebracht werden. Bevorzugt wird die Öffnung in der Mitte des Chips 5 bzw. Chipmoduls eingebracht. Der Durchmesser sollte bevorzugt wenigstens 1 mm groß sein. Beim Einbringen der Öffnung darf die Verbindung zwischen Chip und Antenne jedoch nicht zerstört werden.

Nach dem Einsetzen des mit den Chipkarten 1 bestückten Halterahmens 20 in den ersten Raum 11 des Behandlungsgerätes 10 wird gasförmiges Kohlendioxid (CO₂) in den Exsikkator eingeleitet. Die Einleitung des CO₂-Gases erfolgt beispielsweise für ca. 10 s. Anschließend wird das Behandlungsgerät 10 mit einem Deckel 15 des Behandlungsgeräts 10 dicht verschlossen.

Aufgrund der nun im Laufe der Zeit folgenden Verfärbungen ist es zweckmäßig, eine auf dem Halterahmen 20 angebrachte Markierung auch auf der Außenseite des Behandlungsgeräts 10 anzubringen, um die Orientierung der Chipkarten 1 in dem Halterahmen 20 und damit die Dokumentation der Untersuchung sicherstellen zu können. Die Chipkarten 1 werden für eine vorgegebene Zeit, höchstens jedoch 72 Stunden in dem mit dem Deckel 15 verschlossenen Behandlungsgerät 10 belassen. Durch die darin befindlichen Substanzen Natriumsulfid (NaS), destilliertes Wasser (H₂O) und Kohlendioxid (CO₂) entsteht eine Schwefelwasserstoff (H₂S)-Umgebung, die an Oberflächen aus leitfähigem Material der Chip-Antenne-Verbindungen eine chemische Reaktion hervorruft, aus der eine schwarze Einfärbung resultiert.

Nach dem Ende der vorgegebenen Behandlungs- oder Einwirkzeit wird der Deckel 15 des Behandlungsgeräts 20 entfernt. Dies erfolgt aus Sicherheitsgründen in einem Abzug. Anschließend wird der Halterahmen 20 entnommen, und das in der ersten Schale 16 befindliche Natriumsulfid in eine Vorratsdose zurückgeschüttet und verschlossen. Das Behandlungsgerät 10 verbleibt dann für eine weitere vorgegebene Zeitspanne, z.B. 30 min, 60 min oder länger, offen in dem Abzug.

Anschließend können zur Durchführung von Schritt b) bei einer jeweiligen Chipkarte 1 die elektrischen Verbindungen von Chip 5 und nicht dargestellter Antenne, da im Inneren des Kartenkörpers 2 liegend, mechanisch aufgetrennt werden. Hierzu kann jedes geeignete mechanische Verfahren, z.B. Sägen, Trennen, usw. verwendet werden.

Gemäß Schritt c) erfolgt dann die optische Analyse der aufgetrennten Bereiche, bei der eine Auswertung der eine Einfärbung aufweisenden Flächenbereiche mit den keine Einfärbung aufweisenden Flächenbereichen jeweiliger aufgetrennter Bereiche durchgeführt wird.

Die Schritte b) und c) werden jeweils getrennt bzw. aufeinanderfolgend für die in dem Behandlungsgerät 10 befindlichen Chipkarten durchgeführt.

Die optische Auswertung in Schritt c) erfolgt qualitativer und/oder quantitativer Art, z.B. hinsichtlich der Frage, ob in den jeweiligen aufgetrennten Bereichen der Chip-Antenne-Verbindungen eine Einfärbung vorhanden ist oder nicht. Ebenso kann der prozentuale Anteil eingefärbter Flächenbereiche zur Gesamtfläche eines jeweiligen oder aller aufgetrennten Bereiche bestimmt werden. Ein weiteres Kriterium kann beispielsweise das Flächen-Verhältnis von eingefärbten Bereichen zu nicht eingefärbten Bereichen einer jeweiligen aufgetrennten Chip-Antenne-Verbindung sein.

Die optische Analyse kann durch einen Menschen erfolgen. Alternativ kann die optische Analyse auf Basis eines durch Bilderkennung analysierten Fotos der aufgetrennten Chip-Antenne-Verbindung erfolgen.

Bei ausreichend langer Einwirkung des Schwefelwasserstoffs auf die zu untersuchenden Chipkarten 1 können auch kalte Lötstellen bei Lötverfahren nachgewiesen werden, da sich der Schwefelwasserstoff in die Lötverbindung hineinarbeitet und somit eine schlechte Verbindung aufzeigt.

Mit Hilfe des beschriebenen Verfahrens kann die Qualität der Verbindung zwischen Chip und Antenne optisch zuverlässig aufgezeigt werden. Das Verfahren ist kostengünstig durchführbar und kommt ohne spezielles Messequipment aus. Es ist ein einfacher Nachweis möglich, ob und wo eine Verbindung zwischen dem Chip und der Antenne aufgegangen ist.

## Patentansprüche

1. Verfahren zum Bestimmen der Qualität einer elektrischen Verbindung zwischen einem Chip (5) und einer Antenne einer kontaktlos arbeitenden Chipkarte (1), **dadurch gekennzeichnet, dass** das Verfahren folgende Schritte umfasst:
a) Einbringen einer zu untersuchenden Chipkarte (1) in eine Schwefelwasserstoff-Umgebung, wobei der Schwefelwasserstoff an Oberflächen aus leitfähigem Material eine chemische Reaktion hervorruft, aus der eine Einfärbung resultiert; wobei die Chipkarte (1) in einem ersten Raum (11) eines zwei Räume aufweisenden Behandlungsgeräts (10) gelagert wird, wobei der erste Raum (11) von einem zweiten Raum (12) durch eine Öffnungen (14) aufweisende Trennplatte (13) getrennt ist und in dem zweiten Raum (12) Natriumsulfid angeordnet ist,
b) Auftrennen der elektrischen Verbindung zwischen dem Chip (5) und der Antenne der zu untersuchenden Chipkarte (1); und
c) Durchführen einer optischen Analyse der aufgetrennten Bereiche, bei der eine Auswertung der eine Einfärbung aufweisenden Flächenbereiche mit den keine Einfärbung aufweisenden Flächenbereichen jeweiliger aufgetrennter Bereiche durchgeführt wird.

2. Verfahren nach Anspruch 1, **dadurch gekennzeichnet, dass** in dem zweiten Raum (12) des Behandlungsgeräts (10) gereinigtes Wasser in einem von dem Natriumsulfid getrennten offenen Behälter (17) angeordnet ist.

3. Verfahren nach Anspruch 1 oder 2, **dadurch gekennzeichnet, dass** in das Behandlungsgerät (10) für eine vorgegebene Zeit gasförmiges Kohlendioxid eingeleitet wird, bevor dieses luftdicht verschlossen wird.

4. Verfahren nach einem der vorhergehenden Ansprüche, **dadurch gekennzeichnet, dass** die Chipkarte (1) in dem Behandlungsgerät (10) in einem Halterahmen (20) so gehalten ist, dass sich eine Ebene, in der ihre Hauptfläche liegt, in Schwerkraftrichtung erstreckt.

5. Verfahren nach einem der vorhergehenden Ansprüche, **dadurch gekennzeichnet, dass** die zu untersuchende Chipkarte (1) einen Kartenkörper (2) aufweist, in den der Chip (5) und die Antenne eingebettet sind, wobei vor Schritt a) in den Kartenkörper (2) von der Rückseite her im Bereich des Chips (5) eine Öffnung eingebracht wird.

6. Verfahren nach einem der vorhergehenden Ansprüche, **dadurch gekennzeichnet, dass** in Schritt a) gleichzeitig eine Mehrzahl an zu untersuchenden Chipkarten (1) in die Schwefelwasserstoff-Umgebung eingebracht wird.

7. Verfahren nach einem der vorhergehenden Ansprüche, **dadurch gekennzeichnet, dass** die Lagerung der zu untersuchenden Chipkarte (1) in dem verschlossenen Behandlungsgerät (10) für eine vorbestimmte Zeitdauer erfolgt, wobei die vorbestimmte Zeitdauer maximal mehrere Stunden beträgt.

8. Verfahren nach einem der vorhergehenden Ansprüche, **dadurch gekennzeichnet, dass** die optische Analyse auf Basis eines durch Bilderkennung analysierten Fotos erfolgt.

## Claims

1. Process for determining the quality of an electrical connection between a chip (5) and an antenna of a contactless chip card (1), **characterized in that** the process comprises the steps of:
a) introducing a chip card (1) to be examined into a hydrogen sulfide environment, wherein the hydrogen sulfide brings about a chemical reaction resulting in a colouring of surfaces made of conductive material; wherein the chip card (1) is stored in a first space (11) of a treatment apparatus (10) comprising two spaces, wherein the first space (11) is separated from a second space (12) by a separating plate (13) comprising openings (14) and the second space (12) has sodium sulfide arranged in it,
b) disconnecting the electrical connection between the chip (5) and the antenna of the chip card (1) to be examined; and
c) performing an optical analysis of the disconnected regions in which an evaluation of the surface regions having a colouring with the surface regions of the respective disconnected regions having no colouring is performed.

2. Process according to Claim 1, **characterized in that** the second space (12) of the treatment apparatus (10) has purified water arranged in an open container (17) separate from the sodium sulfide.

3. Process according to Claim 1 or 2, **characterized in that** gaseous carbon dioxide is introduced into the treatment apparatus (10) for a predetermined time before the latter is airtightly sealed.

4. Process according to any of the preceding claims, **characterized in that** the chip card (1) in the treatment apparatus (10) is held in a holder frame (20) in such a way that a plane comprising the main surface of said card extends in the direction of the gravitational force.

5. Process according to any of the preceding claims, **characterized in that** the chip card (1) to be examined comprises a card body (2) in which the chip (5) and the antenna are embedded, wherein an opening is introduced into the card body (2) from the reverse side in the region of the chip (5) before step a).

6. Process according to any of the preceding claims, **characterized in that** step a) comprises simultaneously introducing a plurality of chip cards (1) to be examined into the hydrogen sulfide environment.

7. Process according to any of the preceding claims, **characterized in that** the storage of the chip card (1) to be examined in the sealed treatment apparatus (10) is carried out for a predetermined duration, wherein the predetermined duration comprises at most several hours.

8. Process according to any of the preceding claims, **characterized in that** the optical analysis is carried out on the basis of a photo analyzed by image recognition.

## Revendications

1. Procédé de détermination de la qualité d'une connexion électrique entre une puce (5) et une antenne d'une carte à puce (1) fonctionnant sans contact, **caractérisé en ce que** le procédé comprend les étapes suivantes :
a) introduction d'une carte à puce (1) à examiner dans un environnement d'hydrogène sulfuré, l'hydrogène sulfuré provoquant une réaction chimique conduisant à une coloration de surfaces constituées de matériau conducteur ; la carte à puce (1) étant stockée dans un premier espace (11) d'un appareil de traitement (10) comportant deux espaces, le premier espace (11) étant séparé d'un deuxième espace (12) par une plaque de séparation (13) comportant des ouvertures (14) et du sulfure de sodium étant disposé dans le deuxième espace (12),
b) déconnexion de la connexion électrique entre la puce (5) et l'antenne de la carte à puce (1) à examiner ; et
c) réalisation d'une analyse optique des zones déconnectées, lors de laquelle une évaluation des zones de surface présentant une coloration est effectuée avec les zones de surface ne présentant pas de coloration des zones déconnectées respectives.

2. Procédé selon la revendication 1, **caractérisé en ce que** de l'eau purifiée contenue dans un récipient ouvert (17) séparé du sulfure de sodium est disposée dans le deuxième espace (12) de l'appareil de traitement (10).

3. Procédé selon la revendication 1 ou 2, **caractérisé en ce que** du dioxyde de carbone gazeux est introduit dans l'appareil de traitement (10) pendant une durée prédéterminée avant que celui-ci ne soit fermé hermétiquement.

4. Procédé selon l'une quelconque des revendications précédentes, **caractérisé en ce que** la carte à puce (1) est maintenue dans l'appareil de traitement (10) dans un cadre de support (20) de telle sorte qu'un plan dans lequel se trouve sa surface principale s'étende dans la direction de la gravité.

5. Procédé selon l'une quelconque des revendications précédentes, **caractérisé en ce que** la carte à puce (1) à examiner présente un corps de carte (2) dans lequel la puce (5) et l'antenne sont intégrées, une ouverture étant pratiquée dans le corps de carte (2) depuis la face arrière dans la zone de la puce (5) avant l'étape a).

6. Procédé selon l'une quelconque des revendications précédentes, **caractérisé en ce que**, lors de l'étape a), une pluralité de cartes à puce (1) à examiner est introduite simultanément dans l'environnement d'hydrogène sulfuré.

7. Procédé selon l'une quelconque des revendications précédentes, **caractérisé en ce que** le stockage de la carte à puce (1) à examiner dans l'appareil de traitement (10) fermé hermétiquement se fait pour une durée prédéterminée, la durée prédéterminée étant au maximum de plusieurs heures.

8. Procédé selon l'une quelconque des revendications précédentes, **caractérisé en ce que** l'analyse optique est effectuée sur la base d'une photographie analysée par reconnaissance d'image.
